# EUROPEAN PATENT SPECIFICATION

(11) **EP 0 287 031 B1**
(45) Date of publication and mention of the grant of the patent: **01.02.1995**
(21) Application number: 88105805.1
(22) Date of filing: 12.04.1988
(51) Int. Cl.: H01L 29/41, H01L 21/28

(54) **High breakdown voltage insulating film provided between polysilicon layers**
Hohe Durchbruchspannung aufweisende isolierende Schicht, die zwischen Polysilizium-Schichten liegt
Couche isolante à haute tension de claquage disposée entre des couches de polysilicium

(30) Priority: 14.04.1987 JP 89773/87
(43) Date of publication of application: 19.10.1988
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Mikata, Yuuichi c/o Patent Division, Minato-ku Tokyo 105 (JP); Ishihara, Katsunori, Yokohama-shi (JP)
(74) Representative: Ritter und Edler von Fischern, Bernhard,Dipl.-Ing.

(56) References cited:
- GB-A- 2 120 849
- US-A- 4 584 760
- PATENT ABSTRACTS OF JAPAN, vol. 11, no. 20 (E-472)[2467], 20th January 1987 ; & JP-A-61 190 981
- RCA REVIEW, vol. 44, no. 2, June 1983, pp. 287-312, Princeton, New Jersey, US ; G. HARBEKE et al.: "LPCVD Polycrystalline silicon: Growth and physical properties of in-situ phosphorus doped and undoped films"

## Description

The invention relates to a semiconductor device disclosed in JP-A-61 190 981 and comprising: a semiconductor substrate having a first conductivity type; a first insulating film overlying said semiconductor substrate; a polycrystalline-silicon tri-layer structure on said first insulating film and having a second conductivity type with an upper and a lower surface layer of said polycrystalline-silicon tri-layer structure containing no impurity; and a second film overlying said polycrystalline-silicon tri-layer structure.

JP-A-61 190 981 also discloses a method for manufacturing a semiconductor device having a plurality of layers (52-57) formed on a semiconductor substrate (51) having a first conductivity type, comprising the steps of:
a) forming a first insulating film on a major surface of said semiconductor substrate; and
b) forming on said first insulating film a polycrystalline-silicon tri-layer structure having an impurity of a second conductivity type including an upper and a lower surface layer containing no impurity.

GB-A-2 120 849 discloses a semiconductor integrated circuit capacitor having a thermal oxide layer interposing two silicon layers, one of which is covered by an insulating oxide layer.

RCA Review, vol. 44, no. 2, June 1983, pages 287 - 312 presents investigations of in-situ phosphorus doped LPCVD poly-Si films deposited in the temperature range of 560°C to 640°C. For obtaining phosphorus doped films of highest quality a deposition at temperatures not exceeding 570°C is deemed necessary, whereas films deposited between 580 and 620°C exhibit a lower quality which might still be acceptable for certain applications, and films deposited at temperatures of 620°C and above are considered to be of poor quality.

US-A-4 584 760 discloses a semiconductor device where a polychristalline-silicon layer is formed on an insulating film and on top of the poly-Si layer a metal silicide layer is formed thereon. In order to prevent the metal silicide layer from diffusing into the poly-Si layer to finally reach the interface with the insulating film through various heat treatment processes, the impurity concentration of the poly-Si layer is made different in the depthwise direction. A first poly-Si film may be formed on the insulating film, and a second poly-Si film having a lower impurity concentration than the first poly-Si film is formed on the surface of the first poly-Si film; then a metal film is formed on the second poly-Si film, and the metal film and the second poly-Si film are reacted to form a metal silicide layer.

Known is a semiconductor device of a type which is manufactured by forming a poly-Si film on an insulating film overlying a major surface of a semiconductor substrate, forming an insulating film on the poly-Si film and forming a poly-Si layer, these poly-Si films being employed as an electrode.

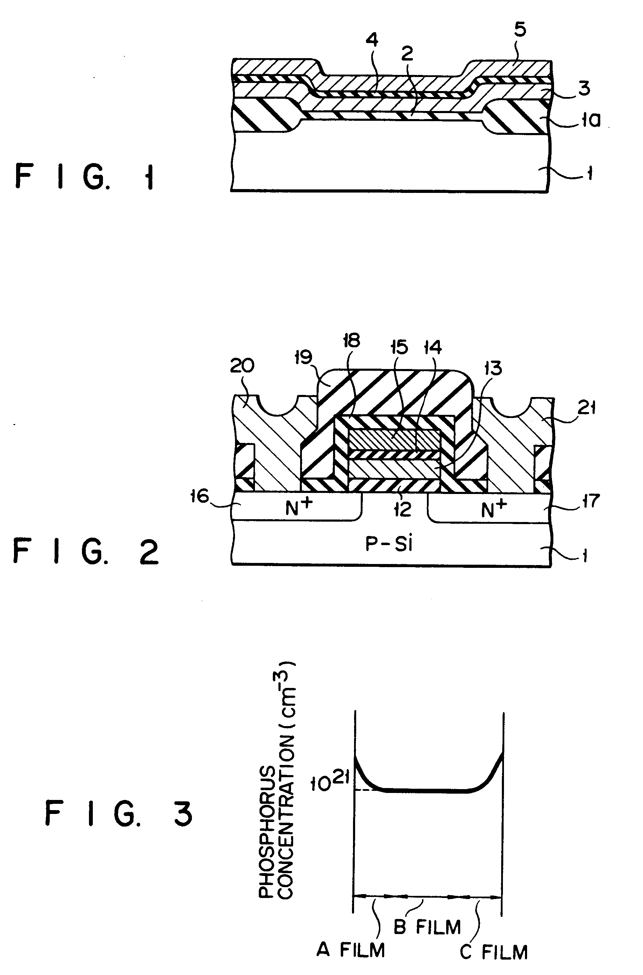

An EPROM is known as this type of a semiconductor device. Fig. 1 is a cross-sectional view showing one of manufacturing steps of a conventional EPROM. In Fig. 1, first thermal oxide film 2 of 500 Å (50 nm) in thickness and field oxide film are formed over the surface of P⁻ type silicon substrate 1, the field oxide film surrounding an element area. First poly-Si layer 3 of 1000 Å (100 nm) in thickness, which is used as a floating gate electrode formation layer, is formed by means of a low-pressure chemical vapor deposition (CVD) method on field oxide film 1 and on first thermal oxide film 2.

Phosphorus are doped by means of a thermal diffusion method into first poly-Si silicon film 3. The surface of first poly-Si film 3 is thermally oxidized at about 1000°C, thereby forming second thermal oxide film 4 having a thickness of 500 Å (50 nm).

Second poly-Si film 5 for control gate electrode formation is formed on the surface of a resultant structure by means of a low-pressure CVD method. Phosphorus are doped by means of a thermal diffusion method into second poly-Si film 5.

Fig. 2 is a cross-sectional view showing a model of a conventional EPROM. An explanation will be given below of the process for manufacturing a conventional EPROM, by referring to Figs. 1 and 2 (a complete view).

Second poly-Si film 5, second thermal oxide film 4, first poly-Si film 3 and first thermal oxidation film 2 are sequentially etched by means of a photoetching method. As a result, control gate electrode 15, second gate oxide film 14, floating gate electrode 13 and first gate oxide film 12 are formed in the semiconductor structure as shown in Fig. 2.

Then an N-type impurity is ion-implanted into a surface portions of the semiconductor structure 1 using control gate electrode 15, second gate oxide film 14, floating gate electrode 13 and first gate oxide film 12 as masks. Substrate 1 is heat-treated, thereby diffusing the N-type impurity deep into substrate 1. As a result, N⁺ type drain region 16 and N⁺ type source region 17 are formed in the semiconductor substrate.

The surface of the resultant structure is thermally oxidized to provide thermal oxide film 18 with which the surfaces of substrate 1 and control gate electrode 15, as well as the side surfaces of second gate oxide film 14, floating gate electrode 14 and first oxide film, are surrounded.

Passivation layer 19, such as a PSG film, is deposited on the whole surface of the resultant surface.

Passivation layer 19 is selectively etched to form contact holes. As a result, the portions of drain region 16 and source region 17 are exposed at the locations of the contact holes. An Aℓ-Si layer is deposited wholly on the surface of the resultant structure, followed by a patterning step to provide drain electrode 20 and source electrode 21. In this way, a conventional EPROM is completed as shown in Fig. 2.

The EPROM is of such a type that it allows the writing of data by the application of a high positive voltage across N⁺ type drain region 16 and control gate electrode 15 and the injection of electrons into floating gate electrode 13.

It is necessary that electrons injected into floating gate electrode 13 be stored in floating gate electrode 13 for a prolonged period of time.

There are cases where, if any high positive voltage is applied to control gate electrode 15 for some accidental reason or other, the electrons thus stored in floating gate electrode 13 are absorbed via second gate oxide film 14 and data is dissipated. This phenomenon that, when a high voltage is applied to control gate electrode 15, electrons stored in floating gate electrode 13 are absorbed via second gate oxide film 14 into control gate electrode 15 is believed to be caused by the following reason.

After deposition of poly-Si film 3 for the formation of floating gate electrode 13, phosphorus are doped by the thermal diffusion into first poly-Si silicon film 3 and the surface of first poly-Si film 3 is thermally oxidized to provide second thermal oxide film 4 as second gate oxide film 14.

After the deposition of second poly-Si film 5 for the formation of control gate electrode 15, phosphorus are doped by a thermal diffusion method into second poly-Si film 5.

Then various thermal treatments are performed at the steps including the formation of thermal oxide film 18.

Phosphorus are doped into first poly-Si film 3 and second poly-Si film 5 and migrated toward first thermal oxide film 2 and second thermal oxide film 4, respectively.

As a result, a phosphorus concentration profile in first poly-Si film 3 and second poly-Si film 5 is as shown in Fig. 3. That is, the phosphorus concentration becomes higher at the outer edge portions A and C of first poly-Si film 3 and second poly-Si film 5.

This means that the phosphorus are diffused into first thermal oxide film 2 and second thermal oxide film 4. As a result, the close density of first thermal oxide film 2 and second thermal oxide film 4 is reduced to reveal the electrical conductivity. The breakdown voltage is thus reduced, permitting the ready electron migration.

When a high voltage is applied to control gate electrode 15, electrons stored in floating gate electrode 13 is absorbed in control gate electrode 15 via second gate oxide film 14.

The object of the present invention is to provide a semiconductor device capable of improving a breakdown voltage on a thin insulating film provided between poly-Si layers and a method for manufacturing the same.

According to the present invention a semiconductor device is provided having the features of independent claim 1. Furthermore the present invention provides a method for manufacturing a semiconductor device, this method comprising the features of independent claim 7. Preferred embodiments of the invention are recited in the dependent claims.

This invention can be more fully understood from the following detailed description when taken in conjunction with the accompanying drawings, in which:
Fig. 1 is a cross-sectional view showing one process for manufacturing a conventional semiconductor device;
Fig. 2 is a cross-sectional view showing the conventional semiconductor device as applied to an EPROM;
Fig. 3 shows a phosphorus concentration profile of a polycrystalline layer of a conventional semiconductor device structure;
Figs. 4A to 4G are views showing a manufacturing process of a semiconductor device of the present invention;
Fig. 5 shows cross-sectional views corresponding to Figs. 4D and 4E which are the steps of manufacturing a semiconductor device of the present invention;
Fig. 6 is a graph showing the phosphorus concentration profile of the first poly-Si layer of a semiconductor device according to the present invention;
Fig. 7 is a view showing a relation, to a second gate breakdown voltage, of the phosphorus concentration of an A film of a first poly-Si layer in a semiconductor device according to the present invention;
Fig. 8 is a view showing a relation, to a gate breakdown voltage, of the phosphorus concentration of a C film of a first poly-Si layer of the semiconductor device according to the present invention; and
Fig. 9 is a graph showing a relation, to a breakdown voltage, of the phosphorus concentration of the insulating films of the conventional semiconductor device and semiconductor device according to the present invention.

The embodiment of this invention will be explained below by referring to the accompanying drawings.

First thermal oxide film (insulating film) 52 of 500 Å in thickness is formed by a thermal oxidation method on the surface of substrate 51 at 700°C to 1100°C in either a dry O₂, H₂O, or HCℓ + O₂ atmosphere (Fig. 4A). Silicon film 53 of at least 30 Å being other than a single crystal type is deposited by a LPCVD method on the resultant structure at a reaction temperature of 400°C to 600°C in a thermally decomposed silane/phosphine gaseous atmosphere (SiH₄/PH₃) (Fig. 4B). Here, being a silicon film other than a single crystalline type means that the film is either an amorphous silicon or polycrystalline silicon (poly-Si), and will be called a non-single crystal type silicon film hereinafter.

When the deposition temperature of film 53 is below 600°C, the crystallization of Si atoms adsorbed on thermal oxide film 52 progresses only slightly in forming non-single crystal silicon film 53.

The reason why the thickness of non-single crystalline type silicon film 53 is 30 Å is because the surface of first thermal oxide film 52 must be covered with non-single crystal type silicon film 53 of a uniform density, and due to the small deposition rate involved in the formation of film 53 by the LPCVD method, a lot of time is required if the thickness of the film is greater than necessary.

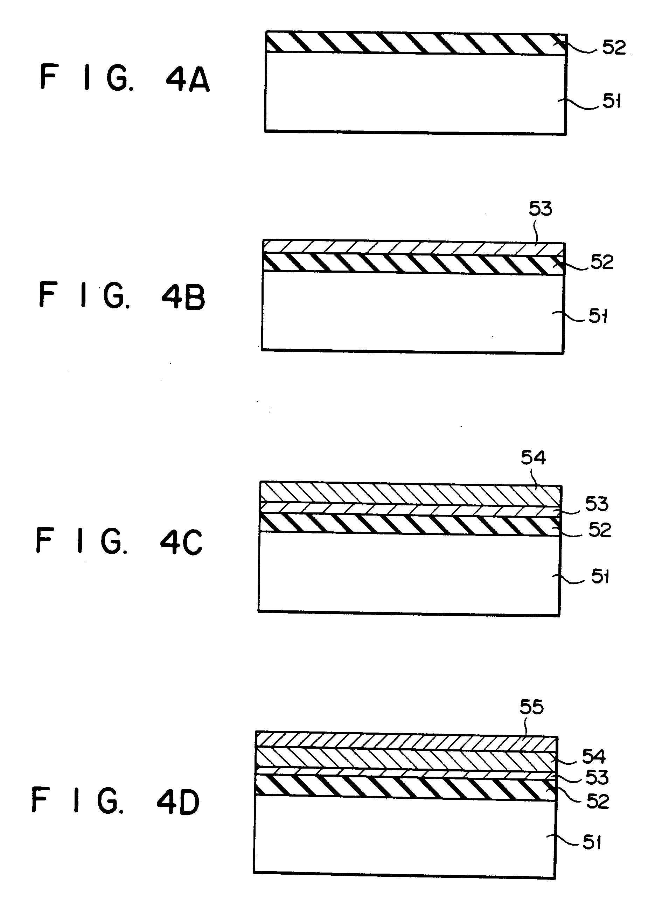

Subsequent to forming non-single crystal type silicon film 53, that is, increasing the reaction temperature to 600° to 800° in the LPCVD device without exposing substrate 51 to an external atmosphere, 1000 Å-thick poly-Si film 54 with a phosphorus concentration of 1 × 10²¹ cm⁻³ is formed on the resultant structure under a thermally decomposed silane/phosphine gaseous atmosphere (SiH₄/PH₃) (Fig. 4C).

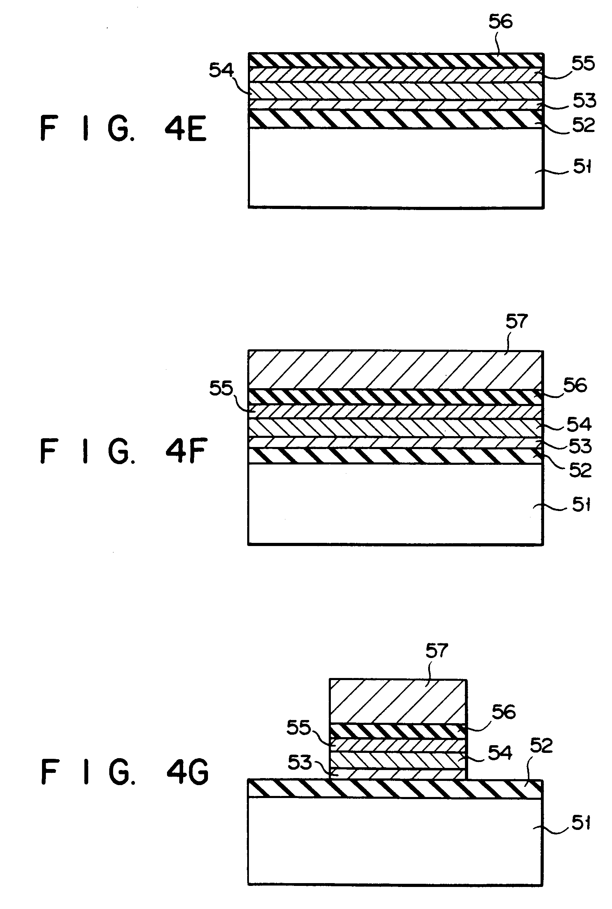

Then 500 Å-thick poly-Si film 55 with a phosphorus concentration of 1 × 10²⁰ cm⁻³ is formed at a reaction temperature of 400° to 800°C in a thermally decomposed silane/phosphine gaseous atmosphere (SiH₄/PH₄) with the use of the LPCVD device (Fig. 4D). The concentration of phosphorus in non-single crystal type silicon film 53 and poly-Si film 55 may be less than 5 × 10²⁰ cm⁻³ and that of phosphorus in poly-Si film 54 may be over 5 × 10²⁰ cm⁻³. It is possible that no phosphorus atoms are contained in non-single crystal type silicon film 53 and poly-Si layer 55. The surface of poly-Si film 55 is thermally oxidized at 700° to 1100°C in either one of a dry O₂ or H₂O atmosphere, or one of a diluted HCℓ/O₂, Ar, or a N₂ atmosphere to form 500 Å-thick second thermal oxide film 56 (insulating film) (Fig. 4E).

Second thermal oxide film 56 serves as a dielectric film of a capacitor if the semiconductor device of the present invention is used for the memory cells of an EPROM. Second poly-Si layer 57 of 3500 Å with a sheet resistivity of 20 Ω is deposited on second thermal oxide film 56 (Fig. 4F).

In the case where the semiconductor device of the present invention is used for memory cells of EPROMs, non-single crystal type silicon film 53, poly-Si film 54, and poly-Si film 55 constitute a floating gate electrode as one electrode of a capacitor, and poly-Si layer 57 constitutes a control gate electrode as the other electrode of that capacitor.

Poly-Si film 57, second thermal oxide film 56, poly-Si film 55, poly-Si film 54 and non-single crystal type silicon film 53 are sequentially etched to provide a capacitor of a memory cell as shown in Fig. 4G.

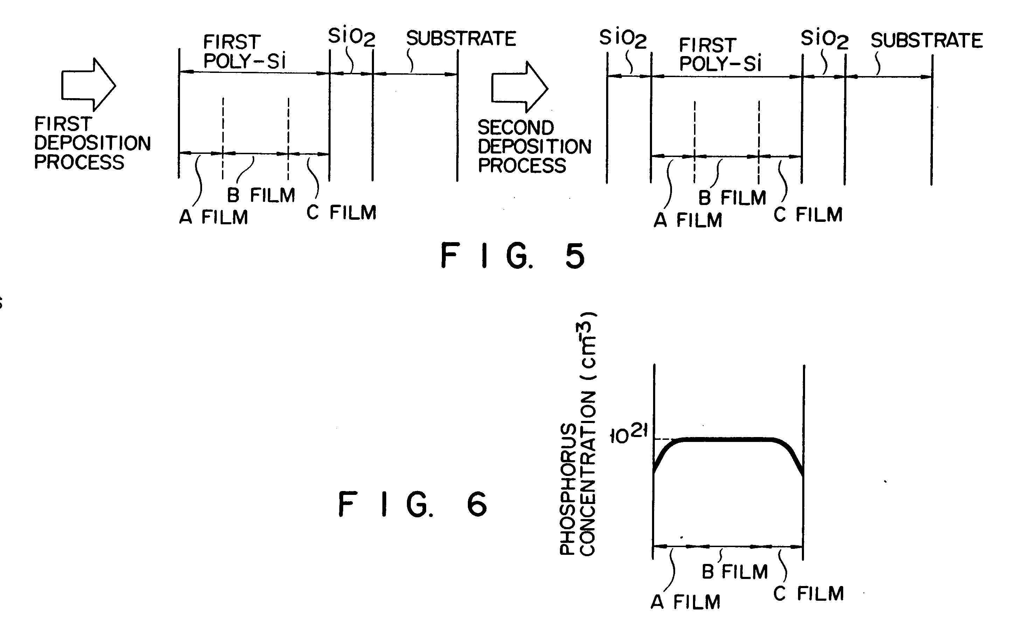

Fig. 5 is a cross-sectional view showing a capacitor, as a model, as shown in Fig. 4E. In Fig. 5, for ease of explanation, a first poly-Si layer is given which is composed of A, B, and C films which correspond to poly-Si film 55, poly-Si film 54 and non-single crystal type silicon layer 53, respectively. It is to be noted that the process involved in the formation of the C film and the formation of the A film is called a first deposition process, and that the process involved in the formation of second thermal oxide film 56 is called a second deposition process.

As shown in Fig. 5, in the first deposition process, silicon is deposited on first insulating film 52 (overlying semiconductor substrate 51) at a reaction temperature of 400°C to 600°C to form a non-single crystal silicon film (C film) in which case the crystallization of the silicon is only slightly developed. Then the reaction temperature is increased to 600°C to 800°C, which is substantially the same temperature as that used in the conventional technique, to form a poly-Si film (A film + B film) and then a first poly-Si layer (A film + B film + C film), wherein the size of the particles are very small; under 100 Å. That is, even if the reaction temperature is at substantially the same level as that of the conventional technique, a poly-Si film having a particle size of under 100 Å can be formed at the same requisite time as in the conventional technique. In the second deposition process, a second insulating film is formed on the second poly-Si film and, in this case, an interface between the first poly-Si film and the second insulating film reveals a more even distribution of the film and a decrease in an impurity trap to allow a high breakdown voltage to be obtained.

The phosphorus of the first poly-Si film formed by the conventional thermal diffusion method has a higher concentration in the C area adjacent to the first insulating film and the A area adjacent to the second insulating film than in the B area as shown in Fig. 3.

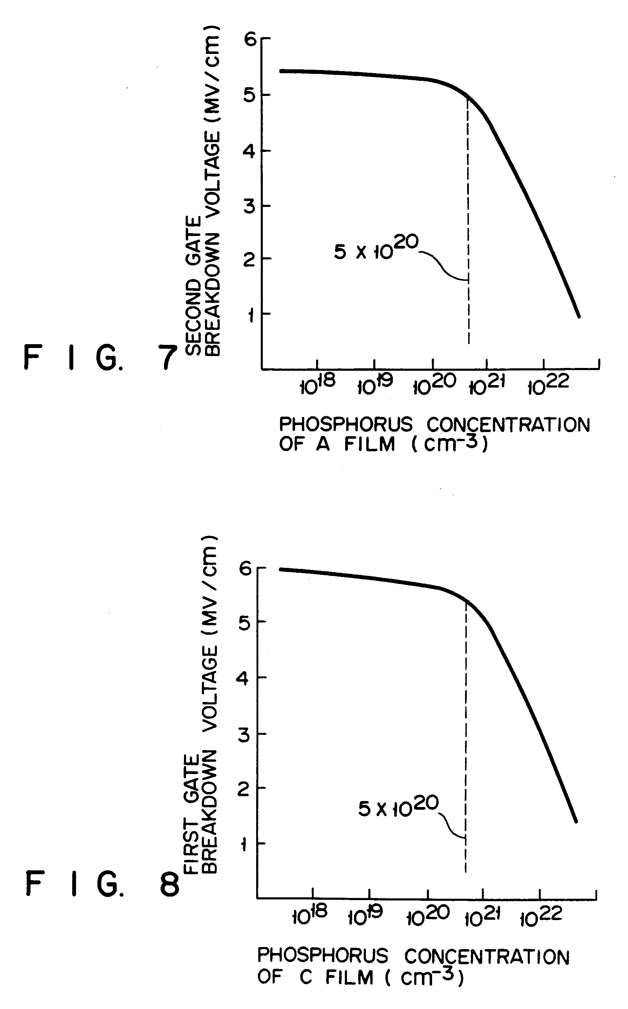

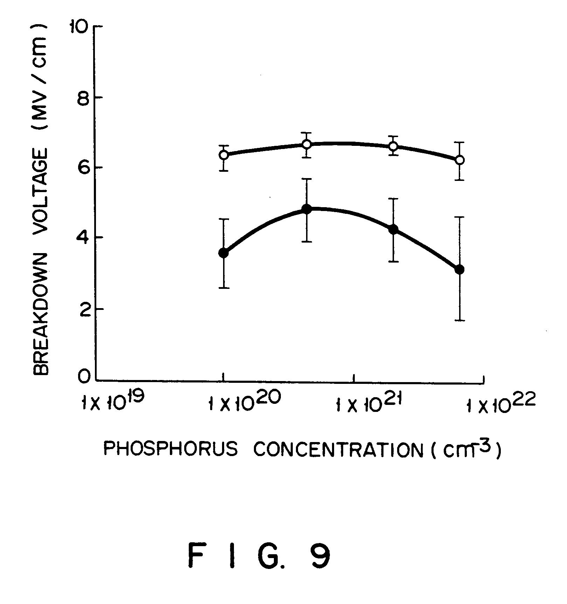

According to the present invention, coupled with an improved film density of the first poly-Si layer, as shown in Fig. 6, the C and A films of the first poly-Si layer contain no phosphorus or are made to have a lower phosphorus concentration level than the B film (an intermediate layer). During the heat treatment the phosphorus ions fail to be diffused from the first poly-Si layer to the first and second insulating films so that the breakdown voltage of the first and second insulating films is increased. Fig. 7 graphically shows the relationship between the second gate breakdown voltage of the second insulating film and the phosphorus concentration of the A layer, and Fig. 8 graphically shows the relationship between the first gate breakdown voltage of the first insulating film and the phosphorus concentration of the C layer. As is evident from the two graphs, a high breakdown voltage of the insulating film is maintained when the phosphorus concentration is less than 5 × 10²⁰ cm⁻³.

Furthermore, because the phosphorous are diffused into the first poly-Si film at the time of its formation, no diffusion of the phosphorus ions occurs after the poly-Si film has been formed, thus shortening the manufacturing process involved.

For the sake of comparison, the breakdown voltage of a capacitor manufactured with the method of the present invention and that of a capacitor manufactured with the conventional method were measured, and the results of which are as shown in Fig. 9.

In the graph shown in Fig. 9, the ordinate denotes the breakdown voltage of second insulating film 56 in terms of the field strength upon the application of a voltage across the first and second poly-Si films, and the abscissa denotes the concentration of phosphorus. In Fig. 9, the open circles show values obtained in accordance with the present invention, the solid circles represent values obtained in using the conventional method, and a vertical crossing portion shows variations in the breakdown voltage. It is obvious from Fig. 9 that the improvement in the breakdown voltage is due to the manufacturing process of the present invention.

## Claims

1. A semiconductor memory device having a floating gate and a control gate comprising:
a semiconductor substrate (51) of a first conductivity type;
a first insulating film (52) formed on said semiconductor substrate (51), said first insulating film being a gate insulating film of the memory device;
a non-single crystal type silicon film (53) formed on said first insulating film (52), containing an impurity of a second conductivity type having a predetermined concentration level;
a first poly-Si film (54) formed on said non-single crystal type silicon film (53), said first poly-Si film (54) containing an impurity of the second conductivity type having a first concentration level;
a second poly-Si film (55) formed on said first poly-Si film (54), said second poly-Si film (55) containing an impurity of the second conductivity type having a second concentration level;
a second insulating film (56) of thermal oxide formed on said second poly-Si film (55); and
a third poly-Si film (57) formed on said second insulating film (56);
wherein said non-single crystal type film (53), said first poly-Si film (54) and said second poly-Si film (55) constitute a floating gate electrode of the memory device, and said third poly-Si film (57) is a control gate electrode of the memory device, and said predetermined concentration level of said non-single crystal type silicon film (53) is sufficiently less than said first concentration level such that no diffusion of the impurity of said first poly-Si film (54) into said first insulating film (52) occurs, and said second concentration level of said second poly-Si film (55) is sufficiently less than said first concentration level of said first poly-Si film (54) such that no diffusion of the impurity of said first poly-Si film (54) into said second insulating film (56) occurs.

2. A semiconductor memory device according to claim 1, characterized in that said predetermined concentration level is less than 5 · 10²⁰ cm⁻³.

3. A semiconductor memory device according to claim 1 or 2, characterized in that said first concentration level is greater than 5 · 10²⁰ cm⁻³.

4. A semiconductor memory device according to claim 1, 2 or 3, characterized in that said second concentration level is less than 5 · 10²⁰ cm⁻³.

5. A semiconductor memory device according to any one of claims 1 to 4, characterized in that said impurity of said second conductivity type is phosphorus.

6. A semiconductor memory device according to any one of claims 1 to 5, characterized in that said first insulating film (52) is thermal oxide film.

7. A method for manufacturing a semiconductor memory device having a floating gate and a control gate, and having a plurality of films (52-57) formed on a semiconductor substrate (51) having a first conductivity type, comprising the steps of:
a) forming a first insulating film (52) on a major surface of said semiconductor substrate (51);
b) forming on said first insulating film (52) a polycrystalline-silicon tri-layer structure (53,54,55) having an impurity of a second conductivity type including an upper and a lower surface layer (53,55) containing an impurity concentration whose level is lower than that of the remainder of the polycrystalline-silicon tri-layer structure (53,54,55);
c) forming a second insulating film (56) of thermal oxide on said polycrystalline-silicon tri-layer structure (53,54,55); and
d) said lower surface film (53) of said polycrystalline-silicon tri-layer structure (53,54,55) being formed as a non-single crystal silicon film (53) in an amorphous state.

8. A method according to claim 7, characterized in that said lower surface film (53) has a phosphorus concentration of less than 5 × 10²⁰ cm⁻³ as an impurity of said second conductivity type, and that said poly-Si tri-layer structure (53,54,55) has a phosphorus concentration of less than 5 × 10²⁰ cm⁻³ and is formed by a LPCVD method in a thermally decomposed silane/phosphine gaseous atmosphere at 400°C to 600°C.

9. A method according to claim 7, characterized in that said upper surface film (55) has a phosphorus concentration of less than 5 × 10²⁰ cm⁻³ as an impurity of said second conductivity type, and that said poly-Si tri-layer structure (53,54,55) is formed by a LPCVD method in a thermally decomposed silane/phosphine gaseous atmosphere at 400°C to 800°C.

10. A method according to claim 7, characterized in that the middle poly-Si film (54) of said poly-Si tri-layer structure (53,54,55) has a phosphorus concentration of over 5 × 10²⁰ cm⁻³ as an impurity of said second conductivity type and that said poly-Si tri-layer structure (53,54,55) is formed by a LPCVD method in a thermally decomposed gaseous silane/phosphine atmosphere at 600°C to 800°C.

## Patentansprüche

1. Halbleiterspeichervorrichtung mit einem Gate mit unbestimmtem Potential und einem Steuergate, mit:
einem Halbleitersubstrat (51) eines ersten Leitfähigkeitstyps;
einem auf dem Halbleitersubstrat (51) ausgebildeten, ersten Isolierfilm (52), welcher einen Gateisolierfilm der Speichervorrichtung darstellt;
einem Nicht-Einkristall-Siliziumfilm (53), der auf dem ersten Isolierfilm (52) vorgesehen ist und eine Verunreinigung eines zweiten Leitfähigkeitstyps mit einem vorbestimmten Konzentrationsniveau aufweist;
einem ersten Polysiliziumfilm (54), der auf dem Nicht-Einkristall-Siliziumfilm (53) vorgesehen ist, und eine Verunreinigung des zweiten Leitfähigkeitstyps mit einem ersten Konzentrationsniveau aufweist;
einem zweiten polysiliziumfilm (55), der auf den ersten Polysiliziumfilm (54) vorgesehen ist und eine Verunreinigung des zweiten Leitfähigkeitstyps mit einem zweiten Konzentrationsniveau aufweist;
einem zweiten Isolierfilm (56), aus thermischem Oxid, der auf dem zweiten Polysiliziumfilm (55) vorgesehen ist; und
einem dritten Polysiliziumfilm (57), der auf dem zweiten Isolierfilm (56) vorgesehen ist;
wobei der Nicht-Einkristall-Siliziumfilm (53), der erste polysiliziumfilm (54) und der zweite Polysiliziumfilm (55) eine Gateelektrode mit unbestimmtem Potential der Speichervorrichtung bilden, und der dritte Polysiliziumfilm (57) eine Steuergateelektrode der Speichervorrichtung bildet, und das vorbestimmte Konzentrationsniveau des Nicht-Einkristall-Siliziumfilms (53) ausreichend niedriger ist als das erste Konzentrationsniveau, so daß keine Diffusion der Verunreinigung des ersten Polysilizumfilms (54) in den ersten Isolierfilm (52) auftritt, und das zweite Konzentrationsniveau des zweiten Polysiliziumfilms (55) ausreichend niedriger ist als das erste Konzentrationsniveau des ersten Polysiliziumfilms (54), so daß keine Diffusion der Verunreinigung des ersten Polysilizumfilms (54) in den zweiten Isolierfilm (56) auftritt.

2. Halbleiterspeichervorrichtung nach Anspruch 1, dadurch **gekennzeichnet**, daß das vorbestimmte Konzentrationsniveau niedriger ist als 5 x 10²⁰ cm⁻³.

3. Halbleiterspeichervorrichtung nach Anspruch 1 oder 2, dadurch **gekennzeichnet**, daß das erste Konzentrationsniveau höher als 5 x 10²⁰ cm⁻³ ist.

4. Halbleiterspeichervorrichtung nach Anspruch 1, 2 oder 3,
dadurch **gekennzeichnet**, daß das zweite Konzentrationsniveau niedriger als 5 x 10²⁰ cm⁻³ ist.

5. Halbleiterspeichervorrichtung nach einem der Ansprüche 1 bis 4,
dadurch **gekennzeichnet**, daß die Verunreinigung des zweiten Leitfähigkeitstyps Phosphor ist.

6. Halbleiterspeichervorrichtung nach einem der Ansprüche 1 bis 5,
dadurch **gekennzeichnet**, daß der erste Isolierfilm (52) ein thermischer Oxidfilm ist.

7. Verfahren zur Herstellung einer Halbleiterspeichervorrichtung, welche ein Gate mit unbestimmtem Potential und ein Steuergate aufweist, sowie mehrere Filme (52 bis 57), die auf einem Halbleitersubstrat (51) eines ersten Leitfähigkeitstyps vorgesehen sind, mit folgenden Schritten:
a) Ausbildung eines ersten Isolierfilms (52) auf einer Hauptoberfläche des Halbleitersubstrats (51);
b) Ausbildung, auf dem ersten Isolierfilm (52), einer dreilagigen Anordnung (53, 54, 55) aus polykristallinem Silizium, welche eine Verunreinigung eines zweiten Leitfähigkeitstyps aufweist, mit einer oberen und einer unteren Oberflächenschicht (53, 55), die eine Verunreinigungskonzentration aufweisen, deren Niveau niedriger ist als jene des Restes der dreilagigen Anordnung (53, 54, 55) aus polykristallinem Silizium;
c) Ausbildung eines zweiten Isolierfilms (56) aus thermischem Oxid auf der dreilagigen Anordnung (53, 54, 55) aus polykristallinem Silizium, und
d) Ausbildung des unteren Oberflächenfilms (53) der dreilagigen Anordnung (53, 54, 55) aus polykristallinem Silizium als Nicht-Einkristall-Siliziumfilm (53) in einem amorphen Zustand.

8. Verfahren nach Anspruch 7,
dadurch **gekennzeichnet**, daß der untere Oberflächenfilm (53) eine Phosphorkonzentration von weniger als 5 x 10²⁰ cm⁻³ als Verunreinigung des zweiten Leitfähigkeitstyps aufweist, und daß die dreilagige Anordnung (53, 54, 55) aus Polysilizium eine Phosphorkonzentration von weniger als 5 x 10²⁰ cm⁻³ aufweist, und durch ein LPCVD-Verfahren in einer thermisch zersetzten Silan/Phosphin-Gasatmosphäre bei 400°C bis 600°C gebildet wird.

9. Verfahren nach Anspruch 7,
dadurch **gekennzeichnet**, daß der obere Oberflächenfilm (55) eine Phosphorkonzentration von weniger als 5 x 10²⁰ cm⁻³ als Verunreinigung des zweiten Leitfähigkeitstyps aufweist, und daß die dreilagige Anordnung (53, 54, 55) aus Polysilizium durch ein LPCVD-Verfahren in einer thermisch zersetzten Silan/Phosphin-Gasatmosphäre bei 400°C bis 800°C ausgebildet wird.

10. Verfahren nach Anspruch 7,
dadurch **gekennzeichnet**, daß der mittlere Polysiliziumfilm (54) der dreilagigen Anordnung (53, 54, 55) aus Polysilizium eine Phosphorkonzentration von mehr als 5 x 10²⁰ cm⁻³ als Verunreinigung des zweiten Leitfähigkeitstyps aufweist, und daß die dreilagige Anordnung (53, 54, 55) aus Polysilizium durch ein LPCVD-Verfahren in einer thermisch zersetzten gasförmigen Silan/Phosphin-Atmosphäre bei 600°C bis 800°C ausgebildet wird.

## Revendications

1. Dispositif de mémoire à semi-conducteur ayant une porte flottante et une porte de commande, ce dispositif comprenant :
un substrat à semi-conducteur (51) d'un premier type de conductivité ;
une première pellicule isolante (52), formée sur ledit substrat à semiconducteur (51), ladite première pellicule isolante étant une pellicule isolante formant porte du dispositif de mémoire ;
une pellicule (53) de silicium du type non monocristallin, formée sur ladite première pellicule isolante (52), contenant une impureté d'un second type de conductivité ayant un niveau prédéterminé de concentration ;
une première pellicule (54) de silicium polycristallin, formée sur ladite pellicule (53) de silicium de type non monocristallin, ladite première pellicule (54) de silicium polycristallin contenant une impureté du second type de conductivité ayant un premier niveau ou taux de concentration ;
une seconde pellicule (55) de silicium polycristallin, formée sur ladite première pellicule (54) de silicium polycristallin, cette seconde pellicule (55) de silicium polycristallin contenant une impureté du second type de conductivité, ayant un second niveau ou taux de concentration ;
une seconde pellicule isolante (56) en oxyde thermique, formée sur ladite seconde pellicule de Si polycristallin (55) ; et
une troisième pellicule (57) de silicium polycristallin formée sur ladite seconde pellicule isolante (56) ;
ladite pellicule (53) de type non monocristallin, ladite première pellicule (54) de silicium polycristallin et ladite seconde pellicule (55) de silicium polycristallin constituant une électrode de porte flottante du dispositif de mémoire, et ladite troisième pellicule (57) de silicium polycristallin étant une électrode formant porte de commande du dispositif de mémoire, et ledit niveau prédéterminé de concentration de ladite pellicule (53) de silicium de type non monocristallin étant suffisamment au-dessous dudit premier niveau de concentration pour qu'il ne se produise pas de diffusion de l'impureté présente dans ladite première pellicule (54) de silicium polycristallin vers ladite première pellicule (52) isolante, et ledit second niveau de concentration dans ladite seconde pellicule (55) de silicium polycristallin étant suffisamment au-dessous dudit premier niveau de concentration dans ladite première pellicule de silicium polycristallin (54) pour qu'il ne se produise pas de diffusion de l'impureté, présente dans ladite première pellicule (54) de silicium polycristallin, vers ladite seconde pellicule isolante (56).

2. Dispositif de mémoire à semi-conducteur selon la revendication 1, caractérisé en ce que le niveau prédéterminé de concentration est inférieur à 5.10²⁰ cm⁻³.

3. Dispositif de mémoire à semi-conducteur selon la revendication 1 ou 2, caractérisé en ce que ledit premier niveau de concentration est supérieur à 5.10²⁰ cm⁻³.

4. Dispositif de mémoire à semi-conducteur selon la revendication 1, 2 ou 3, caractérisé en ce que ledit second niveau de concentration est inférieur à 5-10²⁰ cm⁻³.

5. Dispositif de mémoire à semi-conducteur selon l'une quelconque des revendications 1 à 4, caractérisé en ce que ladite impureté du second type de conductivité est du phosphore.

6. Dispositif de mémoire à semi-conducteur selon l'une quelconque des revendications 1 à 5, caractérisé en ce que ladite première pellicule isolante (52) est une pellicule d'oxyde thermique.

7. Procédé de fabrication d'un dispositif de mémoire à semiconducteur comportant une porte flottante et une porte de commande et ayant plusieurs pellicules (52 à 57) formée sur un substrat (51) à semi-conducteur ayant un premier type de conductivité, le procédé comprenant les étapes consistant à :
a) former un première pellicule isolante (52) sur une surface majeure dudit substrat à semi-conducteur (51); et
b) former, sur ladite première pellicule isolante (52), une structure à trois couches de silicium polycristallin (53, 54, 55) comportant une impureté d'un second type de conductivité, comprenant une couche de surface supérieure et une couche de surface inférieure (53, 55) contenant une concentration d'impureté(s) dont le niveau est inférieur à celui du reste de la structure à trois couches de silicium polycristallin (53, 54, 55) ;
c) former une seconde pellicule isolante (54) en oxyde thermique sur ladite structure à trois couches de silicium polycristallin (53, 54, 55), et
d) ladite pellicule de surface (53) de ladite structure à trois couches de silicium polycristallin (53, 54, 55) étant formée comme pellicule (53) de silicium non monocristallin, à l'état amorphe.

8. Procédé selon la revendication 7, caractérisé en ce que ladite pellicule de surface inférieure (53) présente une concentration en phosphore inférieure à 5 x 10²⁰ cm⁻³ à titre d'impureté dudit second type de conductivité, et en ce que ladite structure à trois couches de silicium polycristallin (53, 54, 55) présente une concentration en phosphore inférieure à 5 x 10²⁰ cm⁻³ et est formée par une méthode de dépôt chimique de vapeur sous faible pression dans une atmosphère gazeuse de silane/phosphine soumise à décomposition chimique à 400°C jusqu'à 600°C.

9. Procédé selon la revendication 7, caractérisé en ce que ladite pellicule de surface supérieure (55) a une concentration en phosphore inférieure à 5 x 10²⁰ cm⁻³ à titre d'impureté dudit second type de conductivité, et en ce que ladite structure à trois couches de silicium polycristallin (53, 54, 55) est formée par un procédé de dépôt chimique en phase vapeur sous faible pression dans une atmosphère gazeuse, soumise à décomposition thermique, de silane/phosphine à 400°C jusqu'à 600°C.

10. Procédé selon la revendication 7, caractérisé en ce que la pellicule médiane (54) de silicium polycristallin de ladite structure à trois couches de silicium polycristallin (53, 54, 55) présente une concentration en phosphore supérieure à 5 x 10²⁰ cm⁻³, à titre d'impureté du second type de conductivité, et en ce que ladite structure à trois couches de silicium polycristallin (53, 54, 55) est formée par une méthode de dépôt chimique en phase vapeur sous faible pression dans une atmosphère gazeuse de silane/phosphine soumise à décomposition thermique à 600°C jusqu'à 800°C.
